# DEMANDE DE BREVET EUROPEEN

(11) **EP 0 772 232 A1**
(43) Date de publication de la demande: **07.05.1997**
(21) Numéro de dépôt: 96202892.4
(22) Date de dépôt: 17.10.1996
(51) Int. Cl.: H01L 23/498

(54) **Procédé de fabrication d'un ensemble de modules électroniques pour cartes à mémoire électronique**

(30) Priorité: 03.11.1995 FR 9513120
(71) Demandeur: SCHLUMBERGER INDUSTRIES, F-92120 Montrouge (FR)
(72) Inventeur: Rose, René, 78190 Voisin-Le-Bretonneux (FR)
(74) Mandataire: Lemoyne, Didier

(57) **Abrégé**

Procédé de fabrication d'un ensemble de modules électroniques pour cartes à mémoire, utilisant des circuits intégrés à protubérances.

Selon l'invention, ledit procédé comporte les étapes suivantes :
a) réalisation, sur un substrat isolant en feuille (10), d'une pluralité de trous traversants (12), destinés à être remplis d'un matériau conducteur afin d'assurer la continuité électrique entre une première et une deuxième faces du substrat, prévues pour recevoir respectivement, des contacts électriques (13) avec un connecteur extérieur et des motifs (14) d'interconnexion avec le circuit intégré à protubérances,
b) sérigraphie desdits contacts électriques sur la première face du substrat (10), lesdits trous (12) étant partiellement remplis de ladite encre,
c) sérigraphie desdits motifs d'interconnexion sur la deuxième face du substrat (10), lesdits trous (12) étant complètement remplis par ladite encre,
d) montage des circuits intégrés à protubérances sur les motifs (14) d'interconnexion.
Application à la fabrication de cartes à mémoire électronique.

## Description

La présente invention concerne un procédé de fabrication d'un ensemble de modules électroniques pour cartes à mémoire électronique, utilisant des circuits intégrés à protubérances.

L'invention trouve une application particulièrement avantageuse dans le domaine de la fabrication des cartes à mémoire électronique dont le circuit intégré, ou puce, peut être soit une mémoire seule EEPROM ou EPROM comme pour les télécartes, soit une mémoire associée à un microprocesseur dans un même circuit comme pour les cartes bancaires.

Les procédés actuellement connus utilisés pour fabriquer des modules électroniques, à l'échelle industrielle, depuis plusieurs années ne permettent plus d'obtenir des réductions significatives des prix de revient. En effet, sur le plan technique, ces procédés, qu'il s'agisse des techniques mettant en oeuvre un substrat isolant et des contacts gravés (circuit imprimé) ou un substrat conducteur (du type "lead frame" métallique), se prêtent mal à la standardisation des modules, ce qui engendre la prolifération des équipements d'assemblage et/ou des outillages. De plus, ils ne permettent pas une évolution vers une autre technologie de montage et d'interconnexion des circuits intégrés communément désignée sous le vocable anglosaxon de "flip chip".

Cette technique consiste à former sur les métallisations d'entrée/sortie du circuit intégré des protubérances constituées d'un ou plusieurs matériaux conducteurs de l'électricité. Après montage sur le substrat, ces protubérances assurent les fonctions de liaison électrique, de maintien mécanique et de conduction thermique. Les avantages de cette technologie sont :
- diminution du nombre d'opérations d'assemblage,
- suppression des fils de câblage qui sont fragiles,
- une seule soudure par métallisation d'entrée/sortie,
- une amélioration du niveau de fiabilité.
- diminution de l'encombrement dans les trois axes puisque les contacts, ici les protubérances, ne débordent pas du périmètre du circuit intégré, et qu'il n'y a pas de boucles de fils en hauteur.

Aussi, le problème technique à résoudre par l'objet de la présente invention est de proposer un procédé de fabrication d'un ensemble de modules électroniques pour cartes à mémoire électronique, utilisant des circuits intégrés à protubérances, procédé qui permettrait d'inclure les avantages de la technologie "flip chip" tant sur le plan économique que technique, et d'assurer une production des modules par lots de grande capacité.

La solution au problème technique posé consiste, selon la présente invention, en ce que ledit procédé comporte les étapes suivantes :
a) réalisation, sur un substrat isolant en feuille, d'une pluralité de groupes régulièrement répartis de trous traversants, chaque groupe de trous étant associé à un module électronique, et lesdits trous traversants étant destinés à être remplis d'un matériau conducteur afin d'assurer la continuité électrique entre une première et une deuxième faces du substrat isolant, prévues pour recevoir respectivement, pour chaque module électronique, d'une part, des contacts électriques de liaison avec un connecteur extérieur et, d'autre part, des motifs d'interconnexion sur lesquels le circuit intégré à protubérances est destiné à être monté,
b) une première sérigraphie consistant à réaliser lesdits contacts électriques par dépôt d'une encre conductrice sur la première face du substrat isolant en feuille, lesdits trous étant partiellement remplis de ladite encre,
c) une deuxième sérigraphie consistant à réaliser lesdits motifs d'interconnexion par dépôt d'une encre conductrice sur la deuxième face du substrat en feuille, lesdits trous étant complètement remplis par ladite encre,
d) montage, sur ladite deuxième face du substrat isolant, des circuits intégrés à protubérances sur les motifs d'interconnexion.

Ainsi, on peut obtenir sur une feuille de 152,4 mm (6 pouces) de côté par exemple une centaine de modules électroniques de surface usuelle.

Il convient de remarquer que la configuration des contacts électriques sérigraphiés sur la première face du substrat isolant est commune aux différentes applications, indépendamment du type de circuits intégrés utilisés, tandis que les motifs d'interconnexion de la seconde face de la feuille de substrat sont spécifiques à un type particulier de circuits intégrés.

Il en résulte la possibilité particulièrement avantageuse consistant en ce que ladite feuille de substrat isolant est stockée après l'étape b) de première sérigraphie et avant l'étape c) de deuxième sérigraphie. On peut alors prévoir d'effectuer la première sérigraphie sur une grande échelle, puis, après séchage et recuit de l'encre conductrice, de stocker les feuilles de substrat isolant ainsi sérigraphiées, celles-ci étant disponibles pour recevoir, selon les besoins, des motifs d'interconnexion particuliers aux circuits intégrés à monter sur les modules électroniques.

Une technique connue de réalisation des cartes à mémoire électronique consiste à placer les modules dans un moule dont les empreintes définissent les cartes aux normes ISO et d'injecter un matériau thermoplastique. Ce matériau thermoplastique peut être un ABS, un polycarbonate ou un matériau de la famille du polyéthylène. Dans ce cas, le substrat isolant en feuille sera choisi de manière à créer des liaisons moléculaires au cours de l'injection, entre ledit substrat et le matériau thermoplastique injecté.

Une autre technique connue de réalisation des cartes est celle de l'assemblage des modules dans les corps de carte auxquels ils sont destinés, consistant à aménager, par moulage ou usinage, une cavité dans lesdits corps de carte et à insérer les modules dans lesdites cavités. A cet effet, il est prévu, selon la présente invention, que, entre l'étape c) de deuxième sérigraphie et l'étape d) de montage, est intercalée une étape de dépôt autour desdits motifs d'interconnexion, d'un matériau d'assemblage des modules électroniques dans des corps de carte à mémoire électronique. Le dépôt peut être réalisé par sérigraphie, collage ou tout autre procédé.

Selon des variantes de l'invention, ledit matériau d'assemblage est une résine époxy réactivable thermiquement, une colle fusible ("hot melt") ou encore un thermoplastique pour soudure par ultra-sons. Dans ce dernier cas, les dimensions du motif doivent permettre la concentration suffisante de l'énergie ultra-sonore.

La description qui va suivre en regard des dessins annexés, donnés à titre d'exemples non limitatifs, fera bien comprendre en quoi consiste l'invention et comment elle peut être réalisée.

La figure 1 est une vue de dessus d'une feuille de substrat isolant perforée de trous traversants.

La figure 2 est une vue de dessus de la première face de la feuille de la figure 1 après sérigraphie de contacts électriques.

La figure 3 est une vue de dessus d'un contact électrique de la figure 2.

La figure 4 est une vue de dessus de la deuxième face de la feuille de la figure 1 après sérigraphie de motifs d'interconnexion.

La figure 5 est une vue de dessus d'un motif d'interconnexion de la figure 4.

La figure 6a est une vue de côté d'un circuit intégré à protubérances.

La figure 6b est une vue de côté du circuit intégré de la figure 6a monté sur la deuxième face d'interconnexion du substrat isolant de la figure 4.

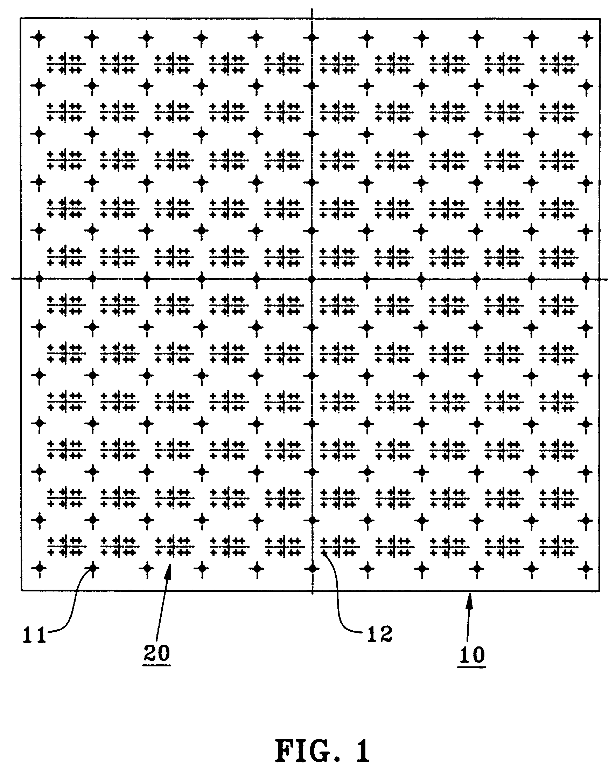

La figure 1 montre en vue de dessus une feuille 10 de matériau isolant prévue pour servir de substrat à un ensemble de modules électroniques comportant des circuits intégrés à protubérances ("flip chip"). Bien entendu, le matériau isolant constituant la feuille 10 de substrat devra être compatible avec la température de cuisson des encres qui seront utilisées par les sérigraphies et avec le type de circuits intégrés à protubérances choisis pour équiper les modules électroniques et aussi au mode de réalisation de la carte. De manière non limitative, les matériaux suivants sont parmi ceux pouvant convenir pour réaliser la feuille 10 de substrat isolant : tissu de verre imprégné époxy, polycarbonate, polyester, polyimide, polyacrylate, polyétherimide.

Le procédé, objet de l'invention, ayant notamment pour objet de fabriquer simultanément un grand nombre de modules électroniques, la surface de la feuille 10 de substrat sera la plus grande possible, tout en restant compatible avec la précision des motifs à imprimer, par exemple 152,4 mm pour 100 modules. L'épaisseur de la feuille 10 est comprise entre 0,1 et 0,2 mm.

Comme l'indique la figure 1, le substrat isolant est percé de trous traversant l'épaisseur de la feuille 10. Cet usinage est réalisé par une machine programmable, de préférence sur une pile de feuilles serrées entre deux plaques de métal.

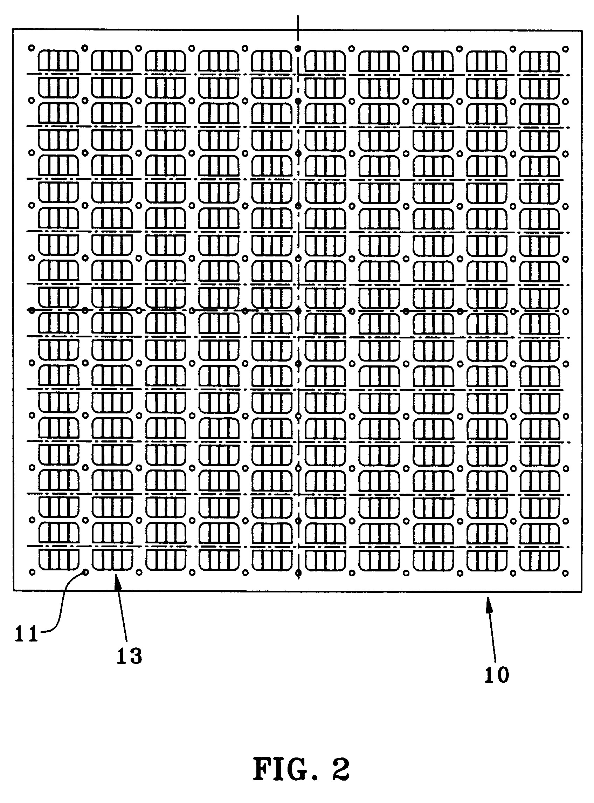

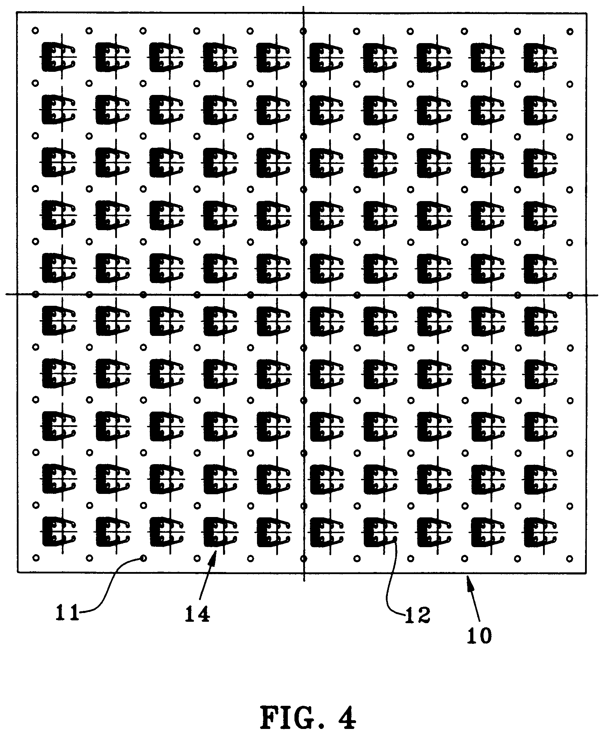

Deux séries de trous sont usinées. D'une part, des trous 11 de grand diamètre ont pour fonction de servir de centrage et d'indexation. D'autre part, des trous 12 de plus petit diamètre, agencés en groupes 20 régulièrement répartis, chaque groupe 20 étant associé à un module électronique. Les trous 12 sont destinés, au cours du déroulement du procédé, à être remplis d'un matériau conducteur afin d'assurer la continuité électrique entre une première face (figure 2) et une deuxième face (figure 4) du substrat isolant.

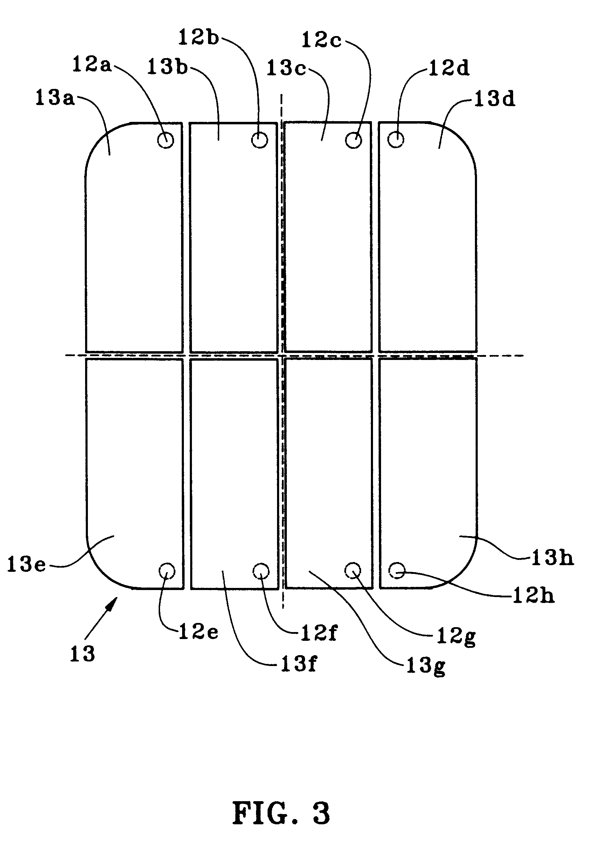

On peut voir sur la figure 2 que la première face de la feuille 10 de substrat est prévue pour recevoir, pour chaque module électronique, des contacts électriques 13 qui, comme le montre mieux la figure 3, comprennent une pluralité, ici de huit plages 13a à 13h, chacune en regard d'un trou traversant 12a à 12h. Lesdits contacts électriques 13 sont réalisés par une première sérigraphie à l'aide d'une encre conductrice, de préférence une encre conductrice chargée argent qui est la technique la plus économique. Lors de cette opération, les trous traversants 12 sont partiellement remplis d'encre conductrice.

Les contacts électriques 13 ainsi obtenus sont dessinés de manière à pouvoir entrer en liaison avec des connecteurs standard de lecteurs de cartes à mémoire électronique. Lesdits contacts 13 sont donc communs aux différentes applications des modules. De ce fait, les feuilles 10 de substrat peuvent être sérigraphiées sur leur première face à une grande échelle, puis stockées après traitement thermique dans l'attente de recevoir sur leur deuxième face une seconde sérigraphie spécifique à un type donné de circuits intégrés.

A moins d'utiliser une encre polymère chargée or ou or/métalloorganique, les contacts électriques 13 sérigraphiés en encre polymère chargé argent peuvent être rechargés par des dépôts métalliques, par exemple nickel puis or, ceci à des fins esthétiques et/ou de compatibilité avec la nature des protubérances des circuits intégrés. La technique utilisée pour recharger les contacts 13 est, par exemple, le procédé dit "electroless" à déplacement d'ions.

Les écrans de sérigraphie sont réalisés à partir de toiles en acier inoxydable d'un nombre de mailles compris entre 200 et 400 mesh.

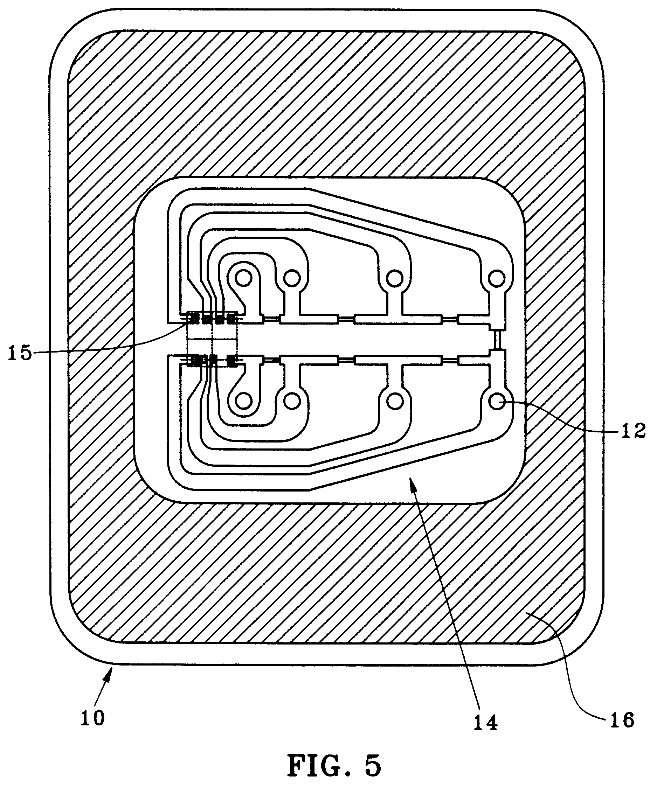

La figure 4 montre la deuxième face de la feuille 10 isolante sur laquelle ont été imprimés, dans une deuxième étape de sérigraphie, des motifs 14 d'interconnexion dont une fonction est de relier électriquement au débouché des trous traversants 12 sur ladite deuxième face des plots 15 de raccordement (figure 5) disposés de manière à recevoir les protubérances des circuits intégrés. On obtient ainsi que chaque protubérance est en liaison électrique avec une et une seule des plages des contacts électriques 13. Il est clair que ce type d'interconnexions est particulier à un circuit intégré donné.

De même, on peut prévoir d'imprimer sur ladite deuxième face, par procédé sérigraphique, collage ou tout autre procédé, un matériau d'assemblage des modules électroniques dans une cavité aménagée dans les corps de cartes à mémoire électronique. Ainsi que le montre la figure 5, ledit matériau 16 d'assemblage est déposé en anneau autour des motifs 14 d'interconnexion. La nature du matériau lui-même peut être une résine époxy réactivable thermiquement ou une colle fusible ("hot melt"). Un thermoplastique peut aussi être imprimé, les dimensions du motif étant déterminées afin de définir un concentrateur d'énergie suffisant pour l'assemblage par ultra-sons des modules dans les corps de cartes.

Si la technique du moulage des cartes avec leur module électronique est retenue, le matériau du substrat du module est, de préférence, un thermoplastique apte à favoriser la création de liaisons moléculaires entre le substrat isolant et le corps de carte.

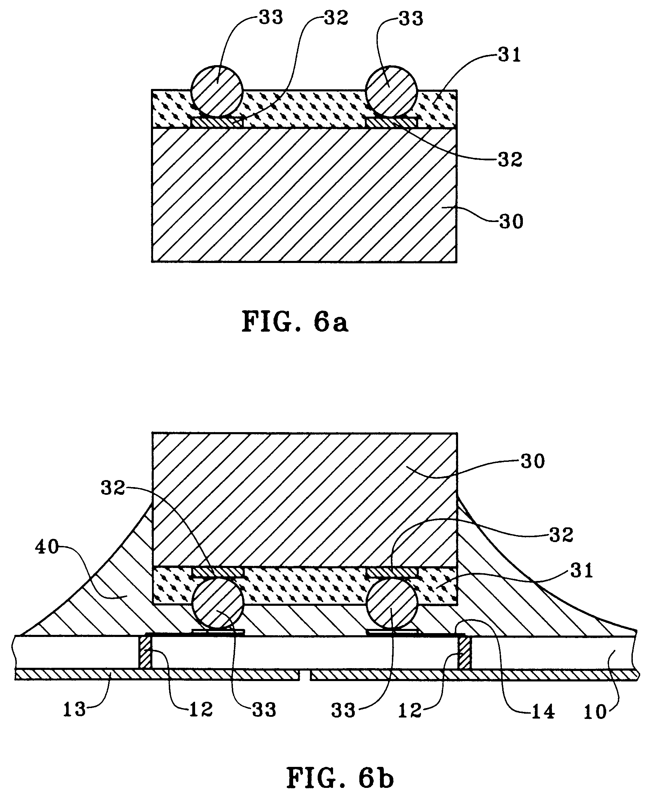

Enfin, dans une dernière étape du procédé, objet de l'invention, les circuits intégrés à protubérances sont montés sur les plots 15 de raccordement des motifs 14 d'interconnexion respectifs. Pour cela, les circuits intégrés auront été préparés d'une manière qui va maintenant être décrite en regard des figures 6a et 6b.

Alors que les circuits 30 sont encore réunis sur une plaque ("wafer"), une couche 31 de diélectrique est déposée par sérigraphie en épargnant les métallisations 32 d'entrée/sortie et les chemins de découpe de la plaque en circuits unitaires. Ensuite, les protubérances 33 sont sérigraphiées au travers d'un masque métallique dont les ouvertures correspondent aux métallisations 32 des circuits 30. Ce masque de grande précision est soit usiné par laser, soit réalisé par croissance électrolytique.

Les protubérances 33 seront de préférence réalisées avec des polymères conducteurs de l'électricité qui, dans l'application aux cartes à mémoire électronique, offrent d'un point de vue mécanique un meilleur découplage du circuit intégré par rapport au corps de carte. Naturellement, pour être compatibles avec le procédé, les métallisations 32 d'entrée/sortie des circuits doivent être faites avec un métal inoxydable ou bien un métal dont l'oxyde est conducteur de l'électricité : or, titane/tungstène, argent, cuivre.

Plusieurs variantes sont à envisager selon la nature du polymère conducteur formant les protubérances :
a) le polymère est une résine époxy chargée argent qui sera polymérisée après sérigraphie.
b) le polymère est une résine époxy chargée argent réactivable, séchée après sérigraphie, et qui sera polymérisée après assemblage du circuit intégré sur le substrat isolant du module.
c) le polymère est un thermoplastique chargé argent.

A ce stade du procédé, la plaque est découpée en circuits unitaires, lesquels sont prêts à être assemblés sur le substrat.

De manière automatique, chaque circuit intégré 30 muni de ses protubérances 33 est prélevé de la plaque découpée, puis retourné de manière à présenter sa face active en regard de la deuxième face d'interconnexion du substrat 10 du module. Après alignement des protubérances sur les plots de raccordement, une pression est appliquée sur le circuit 30 tandis qu'est augmentée la température de la zone du module en cours d'assemblage. Le procédé dépend des variantes choisies pour le matériau polymère conducteur des protubérances :
- dans le cas de la variante a), une sérigraphie supplémentaire sur la deuxième face d'interconnexion du substrat 10 est nécessaire, uniquement sur les plots de raccordement. Ce dépôt de résine époxy, identique à celle des protubérances, est réalisé avec un écran spécifique à chaque type de circuit intégré.
   Le dispositif chauffant de l'équipement n'est pas activé, la polymérisation de la résine époxy est faite ultérieurement après la pose du circuit.
- dans le cas de la variante b), il n'y a pas d'opération supplémentaire. Le dispositif chauffant est activé de façon à assurer le maintien du circuit, la polymérisation complète de la résine époxy est aussi faite ultérieurement,
- dans le cas de la variante c), il n'y pas non plus d'opération supplémentaire. Le dispositif chauffant est activé, la zone du substrat 10 du module en cours d'assemblage sera portée à la température de début de fusion du thermoplastique. La liaison mécanique et électrique sera réalisée pendant le refroidissement. Un autre mode de liaison est la soudure par ultra-sons.

Après ces opérations d'assemblage, une résine fluide 40 peut être dispensée à chaque pastille 30 de manière à former un scellement.

Lorsque la résine 40 est durcie, chaque position de module sur la feuille 10 de substrat est testée en fonctionnalité, les mauvaises positions étant identifiées, exactement comme les circuits intégrés sur leur plaque ("wafer").

Au moment d'être intégrés dans le corps de carte, les modules sont découpés unitairement, les mauvais étant éliminés.

## Revendications

1. Procédé de fabrication d'un ensemble de modules électroniques pour cartes à mémoire électronique, utilisant des circuits intégrés (30) à protubérances (33), caractérisé en ce que ledit procédé comporte les étapes suivantes :
a) réalisation, sur un substrat isolant en feuille (10), d'une pluralité de groupes (20) régulièrement répartis de trous traversants (12), chaque groupe de trous étant associé à un module électronique, et lesdits trous traversants étant destinés à être remplis d'un matériau conducteur afin d'assurer la continuité électrique entre une première et une deuxième faces du substrat isolant (10), prévues pour recevoir respectivement, pour chaque module électronique, d'une part, des contacts électriques (13) de liaison avec un connecteur extérieur et, d'autre part, des motifs (14) d'interconnexion sur lesquels le circuit intégré (30) à protubérances (33) est destiné à être monté,
b) une première sérigraphie consistant à réaliser lesdits contacts électriques (13) par dépôt d'une encre conductrice sur la première face du substrat isolant en feuille (10), lesdits trous (12) étant partiellement remplis de ladite encre,
c) une deuxième sérigraphie consistant à réaliser lesdits motifs (14) d'interconnexion par dépôt d'une encre conductrice sur la deuxième face du substrat en feuille (10), lesdits trous (12) étant complètement remplis par ladite encre,
d) montage, sur ladite deuxième face du substrat isolant (10), des circuits intégrés (30) à protubérances (33) sur les motifs (14) d'interconnexion.

2. Procédé selon la revendication 1, caractérisé en ce que ladite feuille (10) de substrat isolant est stockée après l'étape b) de première sérigraphie, et avant l'étape c) de deuxième sérigraphie.

3. Procédé selon l'une des revendications 1 ou 2, caractérisé en ce que, entre l'étape c) de deuxième sérigraphie et l'étape d) de montage est intercalée une étape de dépôt, autour desdits motifs (14) d'interconnexion, d'un matériau (16) d'assemblage des modules électroniques dans des corps de cartes à mémoire électronique.

4. Procédé selon la revendication 3, caractérisé en ce que ledit matériau (16) d'assemblage est une résine époxy réactivable thermiquement.

5. Procédé selon la revendication 3, caractérisé en ce que ledit matériau (16) d'assemblage est une colle fusible.

6. Procédé selon la revendication 3, caractérisé en ce que ledit matériau (16) d'assemblage est un thermoplastique pour soudure par ultra-sons.

7. Procédé selon la revendication 3, caractérisé en ce que ledit matériau (16) d'assemblage est un thermoplastique apte à favoriser la création de liaisons moléculaires entre le substrat isolant et le corps de carte lorsque les cartes à mémoire électronique sont moulées.

8. Procédé selon l'une quelconque des revendications 1 à 6, caractérisé en ce que ladite feuille (10) de substrat isolant est réalisée dans un matériau thermoplastique apte à créer des liaisons moléculaires avec le corps de carte en matériau thermoplastique lorsque les cartes à mémoire électronique sont moulées.

9. Procédé selon l'une quelconque des revendications 1 à 8, caractérisé en ce que ladite encre conductrice est une encre polymère chargée argent, or ou or/métalloorganique.

10. Procédé selon l'une quelconque des revendications 1 à 9, caractérisé en ce que lesdites protubérances (33) sont en polymère conducteur.
